# EUROPEAN PATENT APPLICATION

(11) **EP 3 975 292 A1**
(43) Date of publication of application: **30.03.2022**
(21) Application number: 20937309.1
(22) Date of filing: 28.10.2020
(51) Int. Cl.: H01M 4/36, H01M 4/505, H01M 4/525

(54) **COBALT-FREE POSITIVE ELECTRODE MATERIAL, PREPARATION METHOD THEREFOR, AND LITHIUM-ION BATTERY**

(30) Priority: 25.05.2020 CN 202010451704
(71) Applicant: SVOLT ENERGY TECHNOLOGY CO., LTD, Changzhou, Jiangsu 213200 (CN)
(72) Inventor: JIANG, Weijun, hangzhou, Jiangsu 213200 (CN); YANG, Hongxin, hangzhou, Jiangsu 213200 (CN); QIAO, Qiqi, hangzhou, Jiangsu 213200 (CN); SUN, Mingzhu, hangzhou, Jiangsu 213200 (CN); XU, Xinpei, hangzhou, Jiangsu 213200 (CN); SHI, Zetao, hangzhou, Jiangsu 213200 (CN); CHEN, Sixian, hangzhou, Jiangsu 213200 (CN); MA, Jiali, hangzhou, Jiangsu 213200 (CN); WANG, Pengfei, hangzhou, Jiangsu 213200 (CN)
(74) Representative: Berggren Oy
(86) International application number: PCT/CN2020/124466
(87) International publication number: WO 2021/238051

(57) **Abstract**

Provided are a cobalt-free positive electrode material, a preparation method thereof and a lithium ion battery. The preparation method includes: first sintering step is performed on a lithium source material and a cobalt-free precursor, to obtain a sintered product; the sintered product is crushed to 1 to 2 µm, to obtain a cobalt-free single crystal material; and second sintering step is performed on the cobalt-free single crystal material, a boron coating agent and a carbon coating agent, to obtain the cobalt-free positive electrode material. The cobalt-free positive electrode material prepared by the above method has advantages of stable structure, high electric capacity, excellent current rate performance and good cycle performance and the like.

## Description

### Technical Field

The disclosure relates to the field of lithium ion batteries, and in particular to a cobalt-free positive electrode material, a preparation method thereof and a lithium ion battery.

### Background

A cobalt-free positive electrode material is a more focused object in the field of lithium ion batteries. Herein, a nickel-manganese layered material becomes a research hotspot in recent years due to advantages of high energy density, lower cost, and good cycle performance and the like. However, it is discovered from researches that a nickel-manganese layered structure with a higher nickel content (mole percentage is greater than 80%) has problems such as structural instability, poor safety, poor cycle performance, high alkalinity, and gas production caused by more side reactions with electrolyte, this causes a practical application of the nickel-manganese layered material to be limited.

A nickel-manganese positive electrode material does not contain a cobalt element, and a content of a nickel element is low, and a content of a manganese element is high. A conductivity of the material is poor, and capacity is relatively low. It may be known according to an existing document that the conductivity of the positive electrode material may be improved to a certain extent by Ti-doped LiNi_{0.5}Mn_{0.5-x}TiₓO₂, and the electric capacity is improved from 150 mAh/g to 180 mAh/g. But this electric capacity is still far lower than an existing high nickel positive electrode material with a electric capacity of 200 to 210 mAh/g. Another existing document also provides an improved method for a LiNi_{0.5}Mn_{0.5}O₂ material, and it includes that, through doping a silicon element, the electric capacity of the positive electrode material may be improved to 192 mAh/g, but the cycle performance is still not ideal, and a maximum retention rate per 100 cycles is only 78%.

In view of the above problems, it is necessary to develop a cobalt-free positive electrode material with high electric capacity and good cycle performance.

### Summary

A main purpose of the disclosure is to provide a cobalt-free positive electrode material, a preparation method thereof and a lithium ion battery, as to solve a problem in an existing lithium ion battery positive electrode material that electric capacity is high, but the cycle performance is poor.

In order to achieve the above purpose, one aspect of the disclosure provides a preparation method for a cobalt-free positive electrode material, and the preparation method includes: a first sintering step is performed on a lithium source material and a cobalt-free precursor, to obtain a sintered product; the sintered product is crushed to 1 to 2 µm , to obtain a cobalt-free single crystal material; and a second sintering step is performed on the cobalt-free single crystal material, a boron coating agent and a carbon coating agent, to obtain the cobalt-free positive electrode material.

Further, the first sintering step includes: a first mixing step is performed on the lithium source material and the cobalt-free precursor, to obtain a first mixture; and, the first mixture is sintered under an air or oxygen atmosphere to obtain the sintered product, preferably, the first mixing step is performed at a stirring speed of 2000 to 3000 rpm, and mixing time is 5 to 20 min.

Further, a temperature of the first sintering step is 700 to 1200°C, and sintering time is 5 to 15 h; and preferably, the temperature of the first sintering step is 900 to 1000°C.

Further, a ratio of a mole number of an Li element in the lithium source material to a sum of mole numbers of a Ni element and a Mn element in the cobalt-free precursor is (0.95 to 1.10) : 1.

Further, the lithium source material is one or more in a group consisting of a lithium hydroxide, a lithium carbonate, a lithium acetate, a lithium oxide, a lithium nitrate, and a lithium oxalate; the cobalt-free precursor is a compound represented by Ni₁₋ₓMnₓ(OH)₂, and 0.45≤x≤0.55; and the boron coating agent is selected from one or more in a group consisting of a boric acid, a boron oxide, a boron nitrate and a metaboric acid, and the carbon coating agent is selected from one or more in a group consisting of a sucrose, a glucose, a polyethylene glycol and a titanium carbide.

Further, the second sintering step includes: a second mixing step is performed on the cobalt-free single crystal material, the boron coating agent and the carbon coating agent, to obtain a second mixture; and the second mixture is sintered, to obtain the cobalt-free positive electrode material; preferably, the preparation method further includes: a product obtained in the second sintering step is sieved, and particles with a particle size ≤ 0.2 µm and particles with a particle size ≥ 6 µm are removed, to obtain the cobalt-free positive electrode material; and preferably, the second mixing step is performed at a stirring speed of 2000 to 3000 rpm, and mixing time is 10 to 20 min.

Further, a temperature of the second sintering step is 300 to 900°C, and treatment time is 10 to 20 min; preferably, D50 of the cobalt-free precursor is 0.5 to 2 µm.

Another aspect of the present application also provides a cobalt-free positive electrode material, and the cobalt-free positive electrode material is prepared by the above preparation method.

Further, in the cobalt-free positive electrode material, a coating amount of a C element is 0.1 to 3%, and a coating amount of a B element is 0.01 to 1%.

Another aspect of the present application also provides a lithium ion battery, including a positive electrode material, herein the positive electrode material includes the above cobalt-free positive electrode material.

A technical scheme of the disclosure is applied, the lithium source material and the cobalt-free precursor are sintered to prepare the layered cobalt-free positive electrode material LiNi₁₋ₓMnₓO₂ (0.45≤x≤0.55), and then it is crushed to 1 to 2 µm, the layered cobalt-free single crystal material may be obtained. During an initial charge-discharge process, the surface of the layered cobalt-free single crystal material may fully contact and react with electrolyte, and a stable positive solid electrolyte interface membrane (SEI) is formed in an initial cycle. Contraction and expansion of charge-discharge in the later cycle may not produce a new crystal boundary interface like polycrystalline particles, and a side reaction may not occur. Therefore, the above cobalt-free single crystal material is capable of greatly reducing gas production in an application process, and improving the cycle performance of the material. At the same time, due to poor conductivity and low capacity of the cobalt-free positive electrode material, its particle size is limited to 1 to 2µm, and is lower than ordinary secondary particles (approximately 10µm) and general single crystal material (approximately 3 to 4µm), this is beneficial to greatly improve the current rate performance of the lithium material compared to a cobalt-containing positive electrode material. In addition, the cobalt-free single crystal material is sintered with the boron coating agent and the carbon coating agent, and a boron carbide coating layer may be formed on the surface of the cobalt-free single crystal material. A boron carbide not only has good conductivity, but also has higher strength and chemical stability. On the basis of the above three reasons, the cobalt-free positive electrode material prepared by the above method has advantages of stable structure, high electric capacity, excellent current rate performance and good cycle performance and the like.

### Brief Description of the Drawings

Drawings of the description for constituting a part of the present application are used to provide further understanding of the disclosure, exemplary embodiments of the disclosure and descriptions thereof are used to explain the disclosure, and do not constitute improper limitation to the disclosure. In the drawings:
Fig. 1 shows a 2000-time scanning electron microscope diagram of a product obtained by crushing treatment according to Embodiment 1 of the disclosure.
Fig. 2 shows a XRD diagram of a cobalt-free positive electrode material prepared according to Embodiment 1 of the disclosure.
Fig. 3 shows a scanning electron microscope diagram of the cobalt-free positive electrode material prepared according to Embodiment 1 of the disclosure at a high magnification of 30,000 times.
Fig. 4 shows resistivity of 2 µm of a non-coated cobalt-free single crystal material, 2 µm of a coated cobalt-free single crystal material and 5 µm of a non-coated cobalt-free single crystal material prepared according to Embodiment 1 of the disclosure.
Fig. 5 shows a charge-discharge curve of the cobalt-free positive electrode material prepared according to Embodiment 1 of the disclosure.
Fig. 6 shows a cycle curve of the cobalt-free positive electrode material prepared according to Embodiment 1 of the disclosure at 45°C.
Fig. 7 shows a scanning electron microscope diagram of a cobalt-free positive electrode material without a coating layer at a high magnification of 20,000 times.

### Detailed Description of the Embodiments

It should be noted that embodiments in the present application and features in the embodiments may be combined with each other in the case without conflicting. The disclosure is described in detail below in combination with the embodiments.

As described in the background, an existing lithium ion battery positive electrode material has a problem that electric capacity is high, but cycle performance is poor. In order to solve the above technical problem, the present application provides a preparation method for a cobalt-free positive electrode material, and the preparation method includes: a first sintering step is performed on a lithium source material and a cobalt-free precursor, to obtain a sintered product; the sintered product is crushed to 1 to 2 µm, to obtain a cobalt-free single crystal material; and a second sintering step is performed on the cobalt-free single crystal material, a boron coating agent and a carbon coating agent, to obtain the cobalt-free positive electrode material.

The lithium source material and the cobalt-free precursor are sintered to prepare the layered cobalt-free positive electrode material LiNi₁₋ₓMnₓO₂ (0.45≤x≤0.55), and then it is crushed to 1 to 2 µm, the layered cobalt-free single crystal material may be obtained. During an initial charge-discharge process, the surface of the layered cobalt-free single crystal material may fully contact and react with electrolyte, and a stable positive Solid Electrolyte Interface membrane (SEI) is formed in an initial cycle. Contraction and expansion of charge-discharge in the later cycle may not produce a new crystal boundary interface like polycrystalline particles, and a side reaction may not occur. Therefore, the above cobalt-free single crystal material is capable of greatly reducing gas production in an application process, and improving the cycle performance of the material. At the same time, due to poor conductivity and low capacity of the cobalt-free positive electrode material, its particle size is limited to 1 to 2µm, and is lower than ordinary secondary particles (approximately 10µm) and general single crystal material (approximately 3 to 4µm), this is beneficial to greatly improve the current rate performance of the lithium material compared to a cobalt-containing positive electrode material. In addition, the cobalt-free single crystal material is sintered with the boron coating agent and the carbon coating agent, and a boron carbide coating layer may be formed on the surface of the cobalt-free single crystal material. A boron carbide not only has good conductivity, but also has higher strength and chemical stability. On the basis of the above three reasons, the cobalt-free positive electrode material prepared by the above method has advantages of stable structure, high electric capacity, excellent current rate performance and good cycle performance and the like.

The above sintering step is an aerobic sintering step, and may be achieved by devices and processes commonly used in the field. In a preferred embodiment, the above sintering step includes: a first mixing step is performed on the lithium source material and the cobalt-free precursor, to obtain a first mixture; and the first mixture is sintered under an air or oxygen atmosphere to obtain the sintered product. Before the sintering step is performed, the lithium source material and the cobalt-free precursor are firstly mixed, and it is beneficial to improve mixing uniformity of the two raw materials and a degree of sintering, thereby it is beneficial to improve the stability of the layered cobalt-free positive electrode material. In order to further improve the stability of the layered cobalt-free positive electrode material, preferably, the first mixing step is performed at a stirring speed of 2000 to 3000 rpm, and mixing time is 5 to 20 min.

In a preferred embodiment, a temperature of the first sintering step is 700 to 1200°C, and sintering time is 5 to 15 h. The temperature and the sintering time of the first sintering step include but are not limited to the above range, and it is beneficial to further improve the stability of the layered cobalt-free positive electrode material through limiting the temperature and the sintering time to the above range. More preferably, the temperature of the first sintering step is 900 to 1000°C.

A nickel-manganese lithium battery prepared by the above preparation method has advantages of stable structure, high electric capacity, excellent current rate performance and good cycle performance and the like. In a preferred embodiment, a ratio of a mole number of an Li element in the lithium source material to a sum of mole numbers of a Ni element and a Mn element in the cobalt-free precursor is (0.95 to 1.10) :1. It is beneficial to further improve the energy density, electric capacity and structural stability of the positive electrode material through limiting the ratio of the mole number of the Li element in the lithium source material to the sum of the mole numbers of the Ni element and the Mn element in the cobalt-free precursor to the above range.

In the above preparation method, the lithium source material and the cobalt-free precursor may be selected from commonly used types in the field. In a preferred embodiment, the lithium source material is one or more in a group consisting of a lithium hydroxide, a lithium carbonate, a lithium acetate, a lithium oxide, a lithium nitrate, and a lithium oxalate; the cobalt-free precursor is a compound represented by Ni₁₋ₓMnₓ(OH)₂, and 0.45≤x≤0.55.

In a preferred embodiment, the second sintering step includes: a second mixing step is performed on the cobalt-free single crystal material, a boron coating agent and a carbon coating agent, to obtain a second mixture; and the second mixture is sintered, to obtain the cobalt-free positive electrode material. The cobalt-free single crystal material is mixed with the boron coating agent and the carbon coating agent, so that the three parties may be mixed more uniformly, to obtain the second mixture. The second mixture is sintered, and a boron carbide coating layer may be formed on the surface of the cobalt-free single crystal material. Because a boron carbide not only has good conductivity, but also has high strength and chemical stability, the cobalt-free positive electrode material prepared by the above method is capable of not only improving its wear resistance, corrosion resistance and electrical conductivity, but also further improving its electric capacity and cycle performance. In order to further improve the uniformity of the boron carbide coating layer and improve the stability of the cobalt-free positive electrode material, more preferably, the second mixing step is performed at a stirring speed of 2000-3000 rpm, and mixing time is 10-20 min.

In a preferred embodiment, the preparation method further includes: a product obtained in a dry coating process is sieved, and particles with a particle size ≤ 0.2 µm and particles with a particle size ≥ 6 µm are removed, to obtain the cobalt-free positive electrode material. It is beneficial to improve the stability of electrical properties of the cobalt-free positive electrode material through sieving the product obtained in the dry coating process.

The cobalt-free positive electrode material coated with the boron carbide may be obtained through the second sintering step. In a preferred embodiment, a temperature of the second sintering step is 300 to 900° C., and treatment time is 10 to 20 min. The temperature and treatment time of the second sintering step include but are not limited to the above range, and it is beneficial to further improve the sintering degree and improve the comprehensive performance of the cobalt-free positive electrode material through limiting the temperature and treatment time to the above range. More preferably, D50 of the cobalt-free precursor is 0.5 to 2 µm.

In the above preparation method, the conductivity, cycle performance and electric capacity of the cobalt-free positive electrode material may be improved by adding the boron coating agent and the carbon coating agent. In a preferred embodiment, the boron coating agent includes but is not limited to one or more in a group consisting of a boric acid, a boron oxide, a boron nitrate and a metaboric acid, and the carbon coating agent includes but is not limited to one or more in a group consisting of a sucrose, a glucose, a PolyEthylene Glycol (PEG) and a Titanium Carbide (TiC). Compared with other boron coating agents and carbon coating agents, the above have advantages of low cost and wide sources. Therefore, it is beneficial to reduce a preparation cost through selecting the above boron coating agents and carbon coating agents. In order to further improve the conductivity of the cobalt-free positive electrode material, more preferably, the carbon coating agent is TiC.

Another aspect of the present application also provides a cobalt-free positive electrode material. The cobalt-free positive electrode material may be represented by LiNi₁₋ₓMnₓO₂, 0.45≤x≤0.55, and the cobalt-free positive electrode material is prepared by the above preparation method.

The lithium source material and the cobalt-free precursor are sintered to prepare the layered cobalt-free positive electrode material LiNi₁₋ₓMnₓO₂ (0.45≤x≤0.55), and then it is crushed to 1 to 2 µm, the layered cobalt-free single crystal material may be obtained. During an initial charge-discharge process, the surface of the layered cobalt-free single crystal material may fully contact and react with electrolyte, and a stable positive Solid Electrolyte Interface membrane (SEI) is formed in an initial cycle. Contraction and expansion of charge-discharge in the later cycle may not produce a new crystal boundary interface like polycrystalline particles, and a side reaction may not occur. Therefore, the above cobalt-free single crystal material is capable of greatly reducing gas production in an application process, and improving the cycle performance of the material. At the same time, due to poor conductivity and low capacity of the cobalt-free positive electrode material, its particle size is limited to 1 to 2µm, and is lower than ordinary secondary particles (approximately 10µm) and general single crystal material (approximately 3 to 4µm), this is beneficial to greatly improve the current rate performance of the lithium material compared to a cobalt-containing positive electrode material. In addition, the cobalt-free single crystal material is sintered with the boron coating agent and the carbon coating agent, and a boron carbide coating layer may be formed on the surface of the cobalt-free single crystal material. A boron carbide not only has good conductivity, but also has higher strength and chemical stability. On the basis of the above three reasons, the cobalt-free positive electrode material prepared by the above method has advantages of stable structure, high electric capacity, excellent current rate performance and good cycle performance and the like.

Preferably, a coating amount of a C element is 0.1 to 3%, and a coating amount of a B element is 0.01 to 1%. It makes the C element and B element play a better synergistic effect with the lithium element, the nickel element and the manganese element through limiting the coating amounts of the C element and B element within the above range, thereby it makes the cobalt-free positive electrode material have the more excellent electrical properties, corrosion resistance and wear resistance.

Another aspect of the present application also provides a lithium ion battery, including a positive electrode material, herein the positive electrode material includes the above cobalt-free positive electrode material.

The cobalt-free positive electrode material provided in present application has the advantages of stable structure, high electric capacity, excellent current rate performance and good cycle performance and the like. Therefore, its electric capacity, current rate performance and cycle performance may be greatly improved by the cobalt-free positive electrode material as the lithium-ion battery.

The present application is further described in detail below in combination with specific embodiments, and these embodiments should not be interpreted as limiting a scope of protection claimed by the present application.

### Embodiment 1

Firstly, lithium hydroxide and precursor Ni₁₋ₓMnₓ(OH)₂ (0.45≤x≤0.55) with a D50 particle size of 1.5 microns are weighed at a molar ratio of Li/(Ni+Mn) of 1.05, and then a high-speed mixing device is used for mixing, and mixing time is 10 minutes. A rotation speed of a laboratory 5L device is 2500 rpm, and material filling efficiency in the device is 50%.

It is reacted at a high temperature of 1000°C for 10 hours (oxygen), and a bulk material sintered by a reaction is crushed with a jet mill, to obtain a single crystal particle product of which a particle size is 1-2 microns mostly.

Dry coating is used for performing boron and carbon co-coating on the above single crystal particles, and a specific process is as follows: a coating agent and the single crystal particle product are added to the 5L mixing device for mixing together, mixing time: 15 minutes, rotation speed: 2500 rpm; herein, the boron coating agent includes a boric acid, and the carbon coating agent includes a sucrose. It is treated at a high temperature of 400 degrees in an inert atmosphere (nitrogen) for 6 hours. After a high temperature treatment, a carbon content of the coating is 1% (wt), and a coating content of the boron is 0.1% (wt). Finally, the material after the high-temperature treatment is air-classified and sieved with 350 meshes, and powder below 0.2 microns and greater than 6 microns is removed, to obtain the final product cobalt-free positive electrode material.

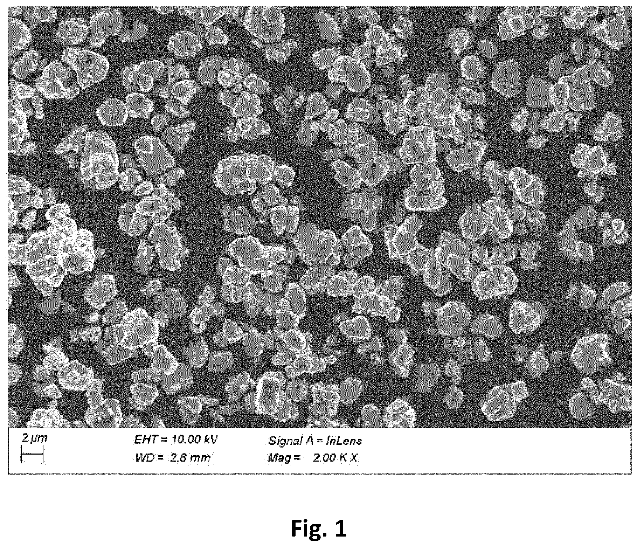

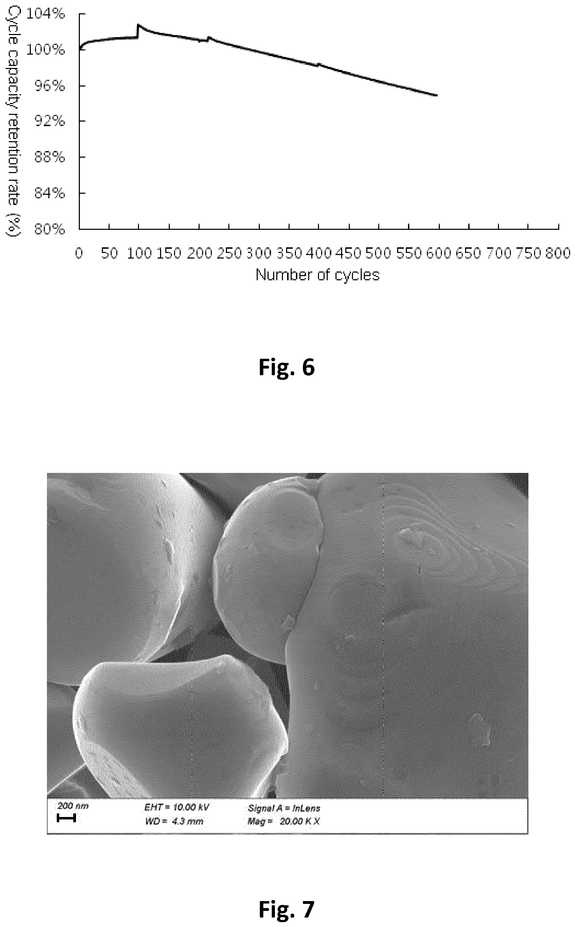

A Zeiss scanning electron microscope is used to detect the product obtained by the crushing treatment, and a spectrum is shown in Fig. 1; and it may be seen from Fig. 1 that the cobalt-free single crystal material is 2 µm of single crystal particles. Fig. 7 shows a scanning electron microscope diagram of a cobalt-free positive electrode material without a coating layer at a high magnification of 20000 times.

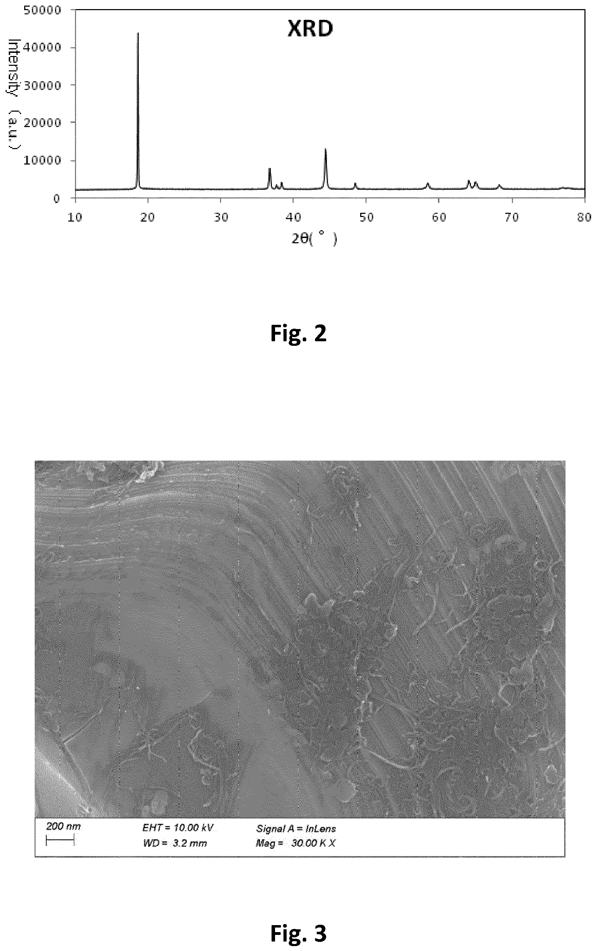

An XRD diffractometer is used to detect compositions of the cobalt-free positive electrode material, and a spectrum is shown in Fig. 2; and it can be seen from Fig. 2 that the cobalt-free positive electrode material belongs to a hexagonal crystal system and a R3-m space group, and has a layered structure.

A scanning electron microscope (SEM) picture of the cobalt-free positive electrode material at a high magnification of 30,000 times is shown in Fig. 3, and it may be clearly seen from Fig. 3 that there are apparent coating materials on the surface of the single crystal particles.

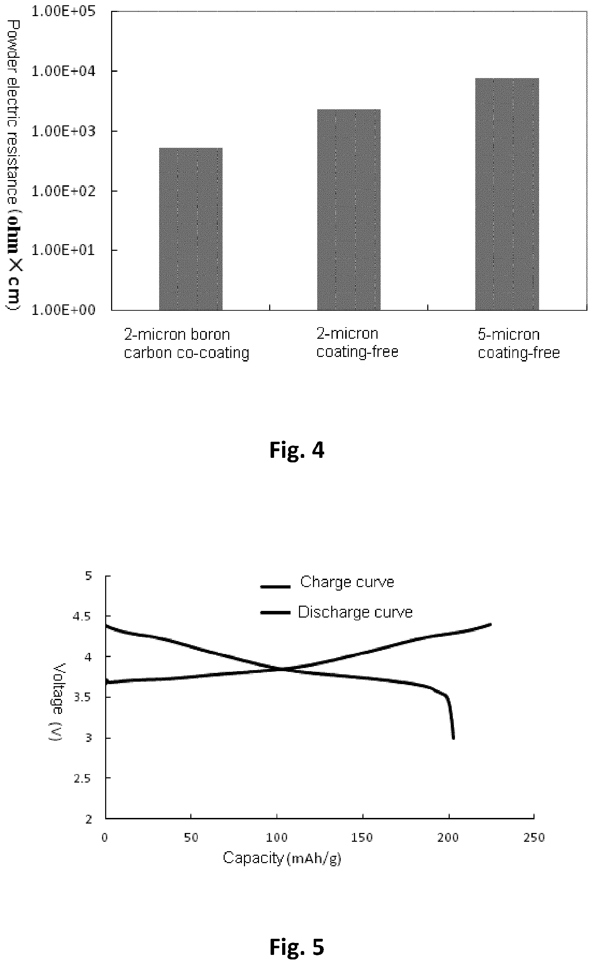

A four-probe tester is used to detect electric resistances of 2µm of an uncoated cobalt-free single crystal material, 2µm of a coated cobalt-free single crystal material, and 5µm of an uncoated cobalt-free single crystal material, and results are shown in Fig. 4. It may be seen from Fig. 4 that compared with 5µm of an uncoated cobalt-free single crystal material, the resistivity of 2µm of the uncoated cobalt-free single crystal material and 2µm of the coated cobalt-free single crystal material are lower. Therefore, the particle size of the cobalt-free single crystal material is limited to 2 µm, and the conductivity of the cobalt-free positive electrode material may be improved by performing carbon-boron coating on it.

A national GB/T 23365-2009 GB/T23366-2009 method is used to detect the charge-discharge performance of the cobalt-free positive electrode material, and a charge-discharge curve is shown in Fig. 5. It may be seen from Fig. 5 that the cobalt-free positive electrode material prepared by the method provided in the present application has the high electric capacity, and it may reach 203 mAh/g.

A GB/T23366-2009 method is used to detect cycle performance of the cobalt-free positive electrode material, and test results are shown in Fig. 6. It may be seen from Fig. 6 that the cobalt-free position electrode material prepared by the method provided in the present application has the good cycle performance, and a 45° C cycle capacity retention rate per 600 cycles is 95%.

### Embodiment 2

A difference from Embodiment 1 is that: a temperature of a first sintering step is 700°C, and a temperature of a second sintering step is 900°C.

A 45°C cycle capacity retention rate of a cobalt-free positive electrode material per 600 cycles is 93%, and a discharge capacity is 210m Ah/g.

### Embodiment 3

A difference from Embodiment 1 is that: a temperature of a first sintering step is 1200°C, and a temperature of a second sintering step is 300°C.

A 45°C cycle capacity retention rate of a cobalt-free positive electrode material per 600 cycles is 97%, and a discharge capacity is 198m Ah/g.

### Embodiment 4

A difference from Embodiment 1 is that: a temperature of a first sintering step is 600°C.

A 45°C cycle capacity retention rate of a cobalt-free positive electrode material per 600 cycles is 80%, and a discharge capacity is 180m Ah/g.

### Embodiment 5

A difference from Embodiment 1 is that: a temperature of a second sintering step is 200°C.

A 45°C cycle capacity retention rate of a cobalt-free positive electrode material per 600 cycles is 82%, and a discharge capacity is 179m Ah/g.

### Embodiment 6

A difference from Embodiment 1 is that: a ratio of a mole number of a Li element in a lithium source material to a sum of mole numbers of a Ni element and a Mn element in a cobalt-free precursor is 0.95:1.

A 45°C cycle capacity retention rate of a cobalt-free positive electrode material per 600 cycles is 93%, and a discharge capacity is 201m Ah/g.

### Embodiment 7

A difference from Embodiment 1 is that: a ratio of a mole number of a Li element in a lithium source material to a sum of mole numbers of a Ni element and a Mn element in a cobalt-free precursor is 1.10:1.

A 45°C cycle capacity retention rate of a cobalt-free positive electrode material per 600 cycles is 96%, and a discharge capacity is 200m Ah/g.

### Embodiment 8

A difference from Embodiment 1 is that: a ratio of a mole number of a Li element in a lithium source material to a sum of mole numbers of a Ni element and a Mn element in a cobalt-free precursor is 1.5:1.

A 45°C cycle capacity retention rate of a cobalt-free positive electrode material per 600 cycles is 91%, and a discharge capacity is 188m Ah/g.

### Embodiment 9

A difference from Embodiment 1 is that: after a second sintering step, a sieving process is not performed.

A 45°C cycle capacity retention rate of a cobalt-free positive electrode material per 600 cycles is 89%, and a discharge capacity is 200m Ah/g.

### Embodiment 10

A difference from Embodiment 1 is that: a coating amount of a C element is 4%, and a coating amount of a B element is 2%.

A 45°C cycle capacity retention rate of a cobalt-free positive electrode material per 600 cycles is 92%, and a discharge capacity is 180m Ah/g.

### Embodiment 11

A difference from Embodiment 1 is that: a carbon coating agent is TiC.

A 45°C cycle capacity retention rate of a cobalt-free positive electrode material per 600 cycles is 96%, and a discharge capacity is 205m Ah/g.

### Contrast Example 1

A difference from Embodiment 1 is that: after crushing, a particle size of a cobalt-free single crystal material is 5 µm.

A 45°C cycle capacity retention rate of a cobalt-free positive electrode material per 600 cycles is 93%, and a discharge capacity is 180m Ah/g.

### Contrast Example 2

A difference from Embodiment 1 is that: there is only the carbon coating layer, and the boron coating layer is missing.

A 45°C cycle capacity retention rate of a cobalt-free positive electrode material per 600 cycles is 90%, and a discharge capacity is 200m Ah/g.

### Contrast Example 3

A difference from Embodiment 1 is that: there is only a boron coating layer.

A 45°C cycle capacity retention rate of a cobalt-free positive electrode material per 600 cycles is 85%, and a discharge capacity is 180m Ah/g.

It may be seen from the above descriptions that the above embodiments of the disclosure achieve the following technical effects.

It may be seen by comparing Embodiments 1 to 11 and Contrast Examples 1 to 3 that the cobalt-free positive electrode material prepared by the method provided in the present application has more excellent cycle performance and electric capacity.

It may be seen by comparing Embodiments 1 to 5 that it is beneficial to further improve the cycle performance and the electric capacity of the cobalt-free positive electrode material through limiting the temperatures of the first sintering step and second sintering stepes within the preferred range of the present application.

It may be seen by comparing Embodiments 1, 6 to 8 that it is beneficial to further improve the cycle performance and electric capacity of the cobalt-free positive electrode material through limiting the ratio of the mole number of the Li element in the lithium source material to the sum of the mole numbers of the Ni element and the Mn element in the cobalt-free precursor within the preferred range of the present application.

It may be seen by comparing Embodiments 1, 10 to 11 that it is beneficial to improve the cycle performance and electric capacity of the cobalt-free positive electrode material by the preferred coating agent of the present application.

It should be noted that terms "first" and "second" and the like in the description and claims of the present application are used to distinguish similar objects, and not necessarily used to describe a specific sequence or precedence order. It should be understood that the terms used in this way may be interchanged under appropriate circumstances, so that the implementation modes of the present application described herein may be implemented, for example, in a sequence other than those described here.

The above are only preferred embodiments of the disclosure, and are not used to limit the disclosure. Various modifications and changes may be made to the disclosure by those skilled in the art. Any modifications, equivalent replacements, improvements and the like made within the spirit and principle of the disclosure should be included in a scope of protection of the disclosure.

## Claims

1. A preparation method for a cobalt-free positive electrode material, wherein the preparation method comprises:
performing a first sintering step on a lithium source material and a cobalt-free precursor, to obtain a sintered product;
crushing the sintered product to 1 to 2 µm, to obtain a cobalt-free single crystal material; and
performing a second sintering step on the cobalt-free single crystal material, a boron coating agent and a carbon coating agent, to obtain the cobalt-free positive electrode material.

2. The preparation method according to claim 1, wherein the first sintering step comprises:
performing a first mixing step on the lithium source material and the cobalt-free precursor, to obtain a first mixture; and
,sintering the first mixture under an air or oxygen atmosphere to obtain the sintered product, preferably, the first mixing step is performed at a stirring speed of 2000 to 3000 rpm, and mixing time is 5 to 20 min.

3. The preparation method according to claim 1 or 2, wherein a temperature of the first sintering step is 700 to 1200°C, and sintering time is 5 to 15 h; and preferably, the temperature of the first sintering step is 900 to 1000°C.

4. The preparation method according to claim 3, wherein a ratio of a mole number of an Li element in the lithium source material to a sum of mole numbers of a Ni element and a Mn element in the cobalt-free precursor is (0.95 to 1.10) : 1.

5. The preparation method according to claim 1, wherein the lithium source material is one or more in a group consisting of a lithium hydroxide, a lithium carbonate, a lithium acetate, a lithium oxide, a lithium nitrate, and a lithium oxalate; the cobalt-free precursor is a compound represented by Ni₁₋ₓMnₓ(OH)₂, and 0.45≤x≤0.55; and the boron coating agent is selected from one or more in a group consisting of a boric acid, a boron oxide, a boron nitrate and a metaboric acid, and the carbon coating agent is selected from one or more in a group consisting of a sucrose, a glucose, a polyethylene glycol and a titanium carbide.

6. The preparation method according to any one of claims 1 to 5, wherein the second sintering step comprises:
performing a second mixing step on the cobalt-free single crystal material, the boron coating agent and the carbon coating agent, to obtain a second mixture; and
sintering the second mixture, to obtain the cobalt-free positive electrode material;
preferably, the preparation method further comprises: sieving a product obtained in the second sintering step, and removing particles with a particle size ≤ 0.2 µm and particles with a particle size ≥ 6 µm, to obtain the cobalt-free positive electrode material; and
preferably, the second mixing step is performed at a stirring speed of 2000 to 3000 rpm, and mixing time is 10 to 20 min.

7. The preparation method according to claim 6, wherein a temperature of the second sintering step is 300 to 900°C, and treatment time is 10 to 20 min;
preferably, D50 of the cobalt-free precursor is 0.5 to 2 µm.

8. A cobalt-free positive electrode material, wherein the cobalt-free positive electrode material is prepared by the preparation method according to any one of claims 1 to 7.

9. The cobalt-free positive electrode material according to claim 8, wherein in the cobalt-free positive electrode material, a coating amount of a C element is 0.1 to 3%, and a coating amount of a B element is 0.01 to 1%.

10. A lithium ion battery, comprising a positive electrode material, wherein the positive electrode material comprises the cobalt-free positive electrode material according to claim 8 or 9.
